# EUROPEAN PATENT APPLICATION

(11) **EP 2 289 843 A1**
(43) Date of publication of application: **02.03.2011**
(21) Application number: 09169073.5
(22) Date of filing: 31.08.2009
(51) Int. Cl.: B81C 1/00

(54) **A microneedle device and method for the fabrication thereof**

(71) Applicant: University College Cork-National University of Ireland, Cork, Cork (IE)
(72) Inventor: The designation of the inventor has not yet been filed
(74) Representative: Purdy, Hugh Barry

(57) **Abstract**

A method of fabricating a microneedle device comprising silicon microneedles formed on a flexible support layer comprises the steps of providing a silicon substrate having a back face and a front face, the back face having a flexible support layer that is resistant to wet-etching, and the front face having a patterned protective masking layer including openings through which etching reagents act on the silicon substrate, and wet etching the silicon substrate through the patterned protective masking layer to provide silicon microneedles formed on the flexible polymer support. The flexible support comprises a material that is resistant to wet-etchants. This means that the material is resistant to corrosion and other forms of degradation during deep-etching processes that employ concentrated aqueous acids or bases.

## Description

### Introduction

The invention relates to a method of fabricating a microneedle device of the type comprising an array microneedles on a flexible polymer support layer.

Many commercial drugs administered using conventional techniques produce a characteristic "Hill and Valley" profile. Administration of the drug into the patient by methods such as injection show drug concentration high with a sharp drop in drug concentration as the drug is metabolized. This initial peak could be toxic with the following sharp drop in dose concentration, ineffective as the body reacts to the new substance intended for patient treatment. In controlled drug delivery small doses of the prescribed drug are released over an extended period and remain within what is termed the therapeutic window for longer periods. This has been shown to provide improved patient treatment. Transdermal drug delivery [TDD] is a possible route to providing controlled drug delivery. For example drugs administrated by transdermal methods avoid degradation within the gastrointestinal track [pills]. Transdermal drug delivery using adhesive patches is an exciting development. Transdermal drug patch delivery can be self administrated, and has the added benefit of fast removal in cases of adverse patient drug reaction to a particular prescribed drug. One of the difficulties associated with TDD delivery is the protective properties of the human skin. The skin acts as a protective barrier against foreign chemical agents. In particular the outer dead skin layer the stratum corneum has been identified as a barrier limiting layer for TDD. The stratum corneum has limited permeability and can restrict drug transport mechanisms such as passive drug diffusion. The typical thickness of the stratum corneum is between 10 to 20um. Using microneedle arrays it is possible to penetrate the stratum corneum, to improve the transport effects of TDD [and by designing the micro-needle height 150 to 300um] and provide painless delivery compared to the invasive route of needle syringes. Painless delivery is possible by limiting microneedles to defined heights in order to avoid penetrating the lower deeper skin tissue housing the internal nerve networks.

Microneedle arrays generally take the form of a rigid silicon substrate having silicon microneedles formed thereon by micromachining processes. A problem with these known devices is that, due to their rigidity, they do not conform well to the irregular and non-planar topography of the skin. One solution to this problem has been described in United States Patent Application No: 2008/0245764 which describes the formation of silicon microneedles on a flexible support, in which the microneedles are initially formed on a silicon substrate in an upside-down orientation, before being affixed to the flexible polymer support is a separate step. This process is a relatively complicated process, and results in microneedles having a relatively blunt tip.

It is an object of the present invention to overcome at least one of the above problems.

### Statements of Invention

The invention relates to a method of fabricating microneedles on a flexible support, especially microneedles formed on a flexible polymer film. As will be apparent from the following description, the microneedles are formed on the flexible support, as distinct to being formed and then affixed to the support. Additionally, the microneedles are formed without a rigid layer connecting the microneedles; that is to say, the substrate from which the microneedles are formed is not continuous to connect the microneedles, rather the microneedles comprise discrete projections supported by, and extending proud of, a flexible support. Generally, the substrate from which the microneedles are formed is silicon, and the flexible support is a polymer layer such as a polymer film. Typically, the microneedles are formed by micromachining. The flexible support needs to be resistant to chemical wet-etchants. Examples of suitable flexible support polymers are provided below.

According to the invention, there is provided a method of fabricating a microneedle device comprising silicon microneedles formed on a flexible support layer, the method comprising the steps of:
- providing a silicon substrate having a back face and a front face, the back face having a flexible support layer that is resistant to wet-etching, and the front face having a patterned protective masking layer including openings through which etching reagents act on the silicon substrate; and
- wet etching the silicon substrate through the patterned protective masking layer to provide silicon microneedles formed on the flexible polymer support.

The method of the invention provides advantages to those of the prior art described above. In particular, as the microneedles are formed in-situ on the flexible support, there is no need for a two step process in which the microneedles are first formed, and then affixed to the flexible support in a separate step. Additionally, the method of the invention provide microneedles of improved characteristics, compared with those of the prior art, especially in terms of sharpness.

In a preferred embodiment of the invention, the process of the invention involves initial steps of providing a silicon substrate with a dielectric hard mask on the front and rear faces of the substrate, patterning the dielectric hard mask on the front face to provide the patterned protective masking layer, removing the dielectric hard mask on the rear face, and applying the flexible protective coating to the rear face before etching the front face..

In an alternative embodiment of the invention, the process of the invention involves initial steps of providing a silicon substrate with a dielectric hard mask on the front face of the substrate and flexible polymer protective coating that is resistant to wet-etching on the rear face of the substrate, and patterning the dielectric hard mask on the front face to provide the patterned protective masking layer before etching the front face.

In a further alternative embodiment of the invention, the process of the invention involves initial steps of providing a silicon substrate with a photosensitive wet etch resistant flexible polymer protective coating on the front face of the substrate and a photosensitive or nonphotosensitive wet etch resistant flexible polymer protective coating on the rear face of the substrate, and patterning the photosensitive flexible polymer protective coating to provide the patterned protective masking layer on the front face.

As mentioned above, the flexible support comprises a material that is resistant to wet-etchants. This means that the material is resistant to corrosion and other forms of degradation during deep-etching processes that employ concentrated aqueous acids or bases. Examples of such materials are provided in US Patent Application No: 2005/0158538 (Assignee Brewer Science Inc.), the contents of which are incorporated herein by reference. Commercially available materials that are resistant to wet-etchants include ProTEK^{™}, ProTEK PS^{™}, and WAFERBOND^{™}. The flexible support is generally a flexible polymer, ideally in the form of a film or membrane.

In embodiments in which the patterned protective masking layer on the front or rear face of the substrate comprises a dielectric hard mask, the dielectric hard mask is typically a bilevel dielectric hard mask. Preferably, the dielectric hard mask comprises a later of oxide and a layer of nitride. Patterning of the hard mask may be carried by any conventional means known in the art, and typically involves the steps of application of a photoresist layer to the hard mask, patterning of the photoresist layer, dry-etching of the hard mask to provide holes in the hard mask, and then wet-etching the front surface to transfer the pattern into the front surface of the silicon substrate.

In embodiments in which the dielectric hard mask is initially provided on the rear face of the substrate, the hard mask is generally removed by conventional wet-etching and dry plasma etching.

In embodiments in which the patterned protective masking layer of the front face is provided by photosensitive protective polymer coating, patterning of the coating is generally carried out by conventional semiconductor lithographic UV methods.

In one embodiment of the invention, the process includes a further step of forming an addition flexible layer on top of the flexible support, partially embedding the microneedles. The thickness of this second flexible layer may be varied to vary the effective height of the microneedles. The flexible layer is generally applied by spincoating, and the material is generally the same as that employed for the flexible support layer.

The substrate material is preferably a silicon wafer, preferably a silicon wafer in which the wafer surface is oriented in the <100> crystal direction. Suitably, the substrate is etched with shallow crystal alignment marks. The substrate is typically from 100 to 2000 microns, preferably from 200 to 500 microns, thick. The diameter of the substrate may be any size, although diameters in the range of 100mm to 450mm are preferred. When employed, the hard mask and flexible protective polymer coating are generally between 0.2um to 0.5um and 0.2 to 50um microns thick, respectively.

In embodiments in which one or both of the faces initially comprises a hard mask, the masking material may include, for example, an oxide layer grown on the surface by any means known in the art, for example, thermal oxidation, and/or a silicon nitride layer deposited by any means known in the art, for example using chemical vapour deposition techniques, and/or a spin-coatable polymeric layer that is resistant to wet alkaline etchants. Other examples of protective mask layers will be known to those skilled in the art. In a preferred embodiment of the invention, the protective mask comprises a layer of oxide, typically silicon oxide, and an overlying later of silicon nitride. Preferably, photosensitive resist is spincoated, irradiated and developed to expose the protective mask.

Patterning of the protective mask is carried out using conventional techniques, such as for example, photolithography. The protective mask is suitably etched to form a patterned mask using wet or dry etching techniques, or a combination of both.

Wet-etching is suitably carried out using an anisotropic wet etchant. Suitably, the wet etchant is an alkaline wet etchant, typically selected from the group consisting of: potassium hydroxide (KOH); tetramethylammonium hydroxide (TMAH); and ethylene diamine pyrocathecol (EDP). The concentration of the wet etchant is variable, but typically in the range of 5 to 50%, 10-40%, 20-35% (w/v). Suitably, the wet etching process is carried out in a bath, ideally a constantly agitated bath. The temperature of the wet etchant may be varied, but generally is above ambient temperature, for example between 40°C and 100°C, 50°C and 90°C, 60°C and 80°C, degrees centigrade. Ideally, the wet etchant is KOH, which is typically employed at a concentration of 29% and a temperature of 79°C.

Some or all of the microneedles formed on the flexible support may be hollow. Techniques for fabricating bores in microneedles will be known to those skilled in the art.

In a further embodiment, the wafer is diced using standard techniques to form arrays of a size suitable for use in pharmaceutical applications.

The invention also relates to a microneedle device comprising an array of microneedles formed on a flexible support and obtainable by the methods of the invention.

The invention also relates to a microneedle device comprising an array of microneedles formed on a flexible support.

As indicated above, the device comprises discrete microneedles affixed to, and extending proud of, a flexible support. Typically, the flexible support is a polymer support, ideally a polymer film. In a particularly preferred embodiment of the invention, the polymer support or polymer film is a polymer that is resistant to wet-etching. Examples of suitable materials are provided below. The flexible support has a thickness of from 0.2 microns to 100 microns, preferably from 0.2 microns to 50 microns, more preferably from 0.2 to 10 microns.

Preferably, the microneedles are formed of a silicon substrate. Generally, the have a height (from tip to base of microneedle) of less than 1000, 900, 800, 700, 600, 500, 400, 300, 200 or 100 microns.

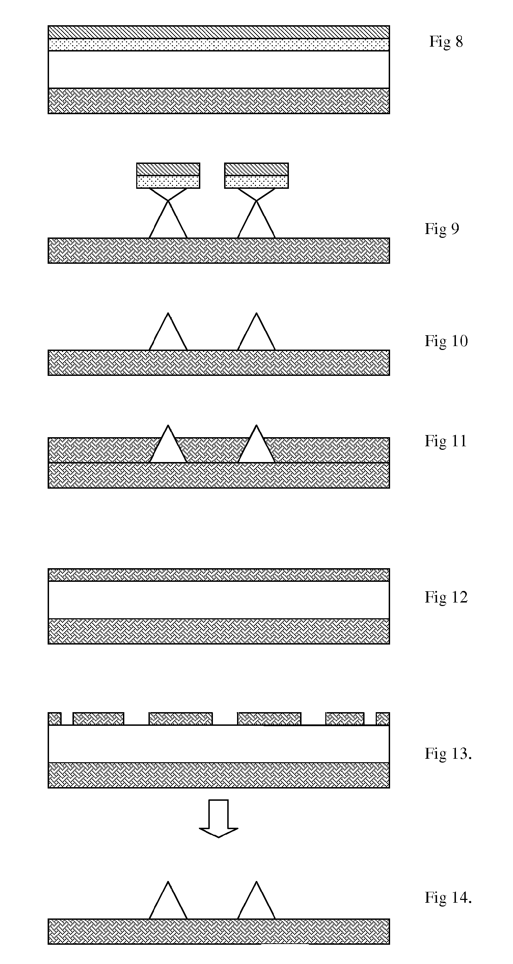

In another embodiment, the device comprises a further layer of flexible support which is formed on the microneedle face of the flexible support and partially covering the array of microneedles. In this way, the effective height of the microneedles may be varied according to the thickness of the second flexible support layer (see Fig. 11 below).

The invention also relates to a drug delivery device comprising a device of, or obtainable by the method of, the invention. The term "drug" as used above should not be construed restrictively, but should be taken to include not only therapeutic substances, but also prophylactic substances such as vaccines, cosmetic substances (i.e. toxins for cosmetic use), diagnostic reagents, and the like. The drug delivery device is typically provided in the form of a flexible layer, such as a flexible patch, plaster, bandage and the like.

The invention also relates to a method of transdermal delivery of an active substance to an individual, the method comprising the steps of placing a device of, or obtainable by a method of, the invention on an individuals skin such that the microneedle(s) formed thereon puncture the strateum corneum layer of the skin, and causing an active substance to be delivered to the individual through the punctures. The term "active substance" as used above should not be construed restrictively, but should be taken to include not only therapeutic substances, but also prophylactic substances, cosmetic substances, diagnostic reagents, and the like.

The device of the invention comprises microneedles formed on a flexible support, generally a flexible polymer support such as a film or membrane. As such, the device is flexible, which means that it is capable of closely following the contours or topography of the applied area, in contrast to conventional microneedle devices which are substantially rigid and unable to conform closely to non-planar application surfaces. Additionally, the flexibility of the device allows the device move with a users skin more easily than a rigid microneedle device.

The device of the invention is applicable for transdermal delivery of an active agent in an individual. In this regard, the term "individual" should not be construed restrictively, but should be taken to include both humans and animals. Further, the device is intended to have application in clinical therapy and prophylaxis, in veterinary applications, and as a research tool.

The invention will be more clearly understood from the following description of some embodiment thereof, given by way of example only, with reference to the accompanying figures.

### Brief Description of the Figures

Fig 1 shows a semiconductor silicon starting substrate.
Fig 2 shows oxidation layers front and back on silicon wafer after thermal oxidation.
Fig 3 shows LPCVD Nitride layers on front and back of Silicon wafer.
Fig 4 shows Zero level crystal alignment marks transferred into the Nitride and oxide masking layers on front silicon surface.
Fig 5 shows transfer of the zero level alignment marks into the Silicon substrate on front silicon surface.
Fig 6 shows transfer of the mask pattern for final definition of Needle arrays into Nitride and oxide layer on front silicon surface.
Fig 7 shows removal of oxide and nitride layers from the back silicon surface.
Fig 8 shows additional of polymer backing flex onto the back silicon wafer surface.
Fig 9 shows typical view of microneedle formation in wet KOH etchant.
Fig 10 shows completed microneedle arrays located on backing polymer film.
Fig 11 shows application of additional polymer layer to further embed the microneedles in the polymer support and to arrange different protruding needle height for required needle based technologies.
Fig 12 shows Silicon substrate coated with photosensitive ProTEK on front and nonphotosensitive ProTEK on back. Photosensitive Protek replacing oxide and nitride masking layers.
Fig 13 shows opening of the front photosensitive polymer protective layer by convential lithography using UV light and subsequent removal of unwanted polymer through wet or dry development techniques.
Fig 14 shows final fabricated Silicon Microneedles on ProTEK Flexible support after wet bulk micromachining.

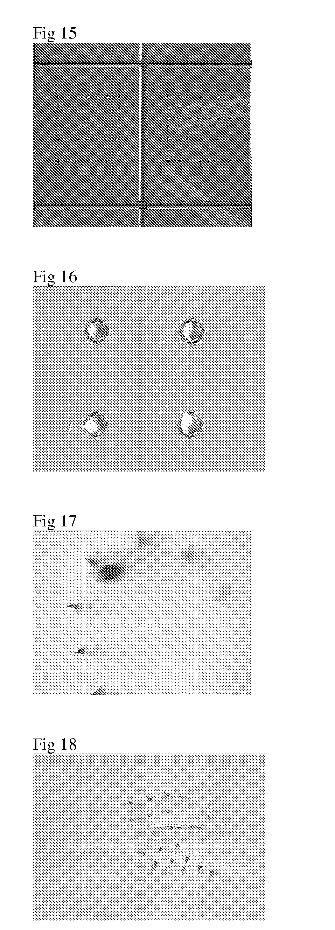

Fig 15 shows Silicon Microneedles on Transparent Polymer ProTEK support. Silicon wafer support beams.
Fig 16 shows Close Up of Silicon MicroNeedles on ProTEK Polymer Support.
Fig 17 shows Polymer support & Silicon Microneedles curved around standard syringe needle tip.
Fig 18 shows Standard Syringe Receptacle showing inserted Polymer ProTEK membrane with Microneedles.

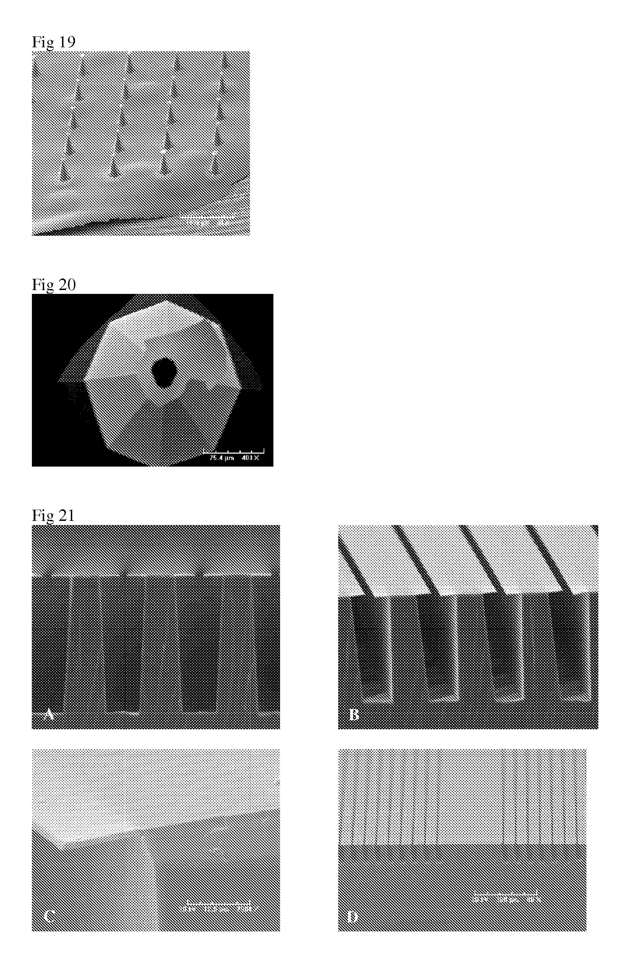

Fig 19 shows Silicon Microneedles on ProTEK membrane
Fig 20 shows Top view of Microneedles showing Nitride Oxide masking during final stages of MicroNeedle formation.
Fig 21 Electron Micrographs of ProTEK PS Formulation (A-D).

Pictures show silicon trials performed using Photosensitive Formulation of ProTEK.

The protective membrane is intact and does not collapse during a 45min KOH etch. The protective polymer membrane replaces the standard oxide and nitride masking required for KOH bulking micromachining.

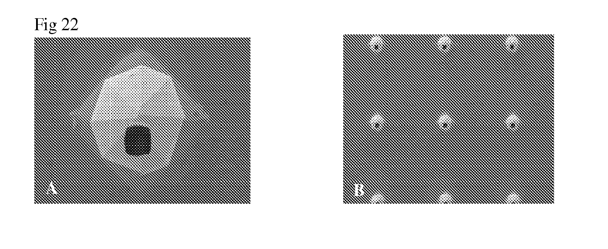

Fig 22 shows pictures of Silicon Hollow Microneedles which can be fabricated using the inventive method described. A) Single Hollow Silicon Needle B) Arrays of Silicon Hollow Micro-Needles

### Detailed Description of the Invention

In general this invention is directed to the aforementioned need in the art and provides a cost effective method of fabricating Silicon Micro-Needle devices directly onto a supporting flexible polymer layer, such as the commercially available wet etch resistant polymers ProTEK, ProTEK PS & Waferbond as examples. The starting material is typically a silicon microelectronic substrate with a polymer protective flex coating that can be directly applied to one or both faces of a silicon substrate. The Applicant has surprisingly discovered that photosensitive and/or non-photosensitive spin-on wet etch protective coatings may be employed to fabricate Silicon Micro-Needle structures directly onto a flexible polymer membrane using wet chemistry. Both photosensitive and non-photosensitive protective etch polymer coating formulations can be fully implemented into the fabrication method to fabricate flexible silicon Micro-Needles. The photosensitive protective coating replaces the standard oxide and nitride hard mask requirement in the fabrication of Silicon Micro-Needles by wet bulk micromachining. The invention provides a novel fabrication method that delivers Silicon Microneedles directly onto the polymer protective coatings employed in the protection of silicon during bulk micromachining fabrication. The flexible membrane is not affixed as described in previous prior art {US 2008/0245764 A1} to the final device after needle formation but incorporated into the Microneedle fabrication process.

In one embodiment an applied polymer film of polystyrene co-acryonitrile (also know as ProTEK & ProTEK PS) acts as a masking material protecting the silicon back face from wet etchant attack and allowing a silicon microneedle to be formed from previously patterned front dielectric masking onto the flexible [flex] membrane. The current invention uses commercial spin-on photosensitive and non-photosensitive ProTEK protective polymer coatings derived from styrene acrylonitrile, which exhibit resistance to silicon wet etchants, TMAH , KOH , EDP and other similar wet chemistry used in the semiconductor industry for the fabrication of silicon Micro- Needle type structures.

In another embodiment of the invention, the introduction of photosensitive polymer wet etch protective coatings for the wet bulk micromachining of silicon needles can also replace the dielectric masking materials, silicon nitride and silicon oxides.

In one embodiment, the method of the invention encompasses the following process steps:
1. A silicon semiconductor substrate crystal orientation <100>
2. Deposition of dielectric hard mask of oxide and nitride onto front and rear silicon surface.
3. Pattern transfer into Hard mask exposing underlying silicon areas.
4. Removal of protective hard mask from rear silicon surface
4. Application of polymer protective coating to the rear surface of silicon semiconductor substrate.
5. Bulk Micro-machining using wet silicon etchants of exposed silicon areas to provide Silicon Microneedles.

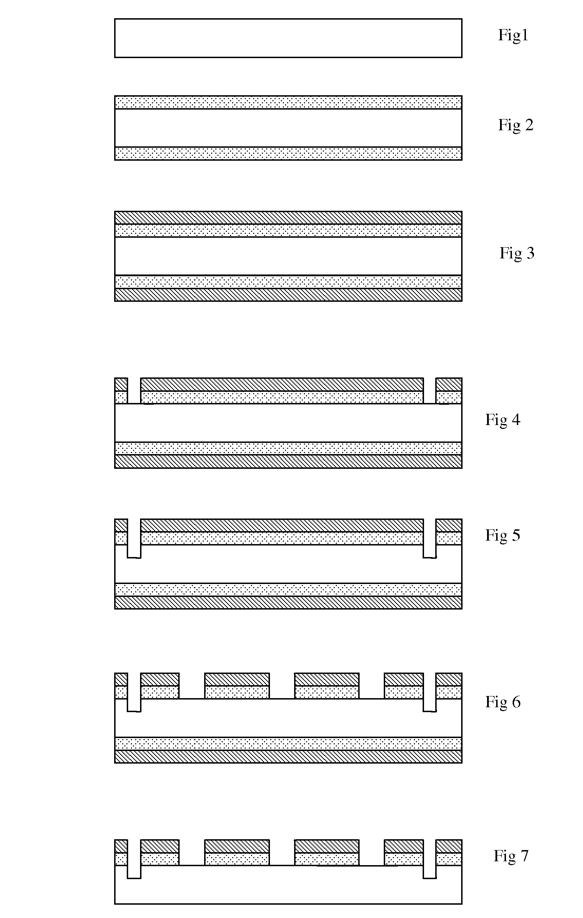

In the method thus described a silicon semiconductor substrate [Fig 1] 300um thick is coated with a thin silicon oxide 35nm using a standard thermal oxidation approach performed in a Furnace [Fig 2]. This oxide is part of a bilevel dielectric hard mask. The second dielectric layer, is the deposition of a nitride film 100nm thick by low pressure chemical vapour deposition [LPCVD Fig 3]. Standard semiconductor application of positive photoresist together with exposure and development of exposed UV areas is performed. A dedicated contact mask plate is used to enable pattern transfer of zero level silicon crystal location markers into the applied photoresist film. The resulting exposed bilevel layers of nitride and oxide [removed photoresist areas] are then dry etched using C4F8, Helium and Hydrogen as the plasma etch reagent. This plasma dry etching step transfers the photoresist pattern into underlying bilevel dielectric layers of nitride and oxide [Fig 4]. The photoresist is removed using standard photoresist stripping methods of oxygen plasma ashing and wet piranha cleans. The wafers are immersed in the wet etchant potassium hydroxide [KOH] 30% concentration to transfer the original crystal location pattern into the exposed silicon substrate [Fig 5]. Only exposed silicon areas are removed in the KOH etch solution. The remaining silicon surface is protected by the unpatterned nitride & oxide hard mask.

A new photoresist imaging layer is applied using standard lithography tools. Exposure and development of this photoresist layer provides isolated islands of photoresist. These islands are transferred into the nitride and oxide layers using Hydrogn, Helium and C4F8 based plasma dry etching technology [Fig 6]. The photoresist is removed using standard photoresist stripping methods of oxygen plasma ashing and wet piranha cleans.

Removal of the nitride and oxide layers on the back of the silicon substrate is performed. A number of different approaches can be employed in this embodiment the removal was completed using dry plasma etch. Prior to application of the polymer backing surface activation is performed using oxygen plasma or ion bombardment using inert gases such as Ar. Primer activation is also used using a commercial dedicated organosilane spin applied primer. These priming methods ensure enhanced adhesion of the protective polymer to the silicon substrate. The protective and flexible polymer ProTEK and or ProTEK PS support is spin applied and baked [Fig 8].This polymer provides 2 dual functions. It acts as the final flexible support for completed microneedles and also acts as a polymer protective barrier to KOH enabling the front wet etch definition of Micro-Needles [Fig 8].

The silicon wafer with protective polymer backing and patterned nitride and oxide bilevel on the silicon front face is then immersed in KOH etching solution for a predetermined time to allow formation of completed arrays of Silicon Microneedles. The KOH etchant is an anistropic etchant and the polymer backing acts as an etch stop. Figure 9 shows the final stages of the bulk micromachining process in KOH.

The final device is outlined in Figure 10 where completed Silicon microneedle arrays are produced on the protective and flexible polystyrene co-acryonitrile polymer {ProTEK/ProTEK PS} support.

Hollow Micro-Needles on a flexible support of ProTEK formulations, Waferbond or combinations together with other similar wet etch polymer based protection systems can also be fabricated using the inventive method. Definition of the through hole is performed after completion of solid Micro-Needle profile by dry plasma etch. The Silicon through hole is dry etched from the back of the needle base using an additional photoresist etch mask to allow etching of the silicon channel while protecting the polymer flexible base during the dry etching process.

The invention is not limited to the embodiments herein before described which may be varied in construction and detail without departing from the spirit of the invention. For example, a replacement masking material of photosensitive or nonphotosensitive flexible support (i.e. ProTEK formulations) may replace the oxide and nitride front masking. Patterning of the replacement photosensitive flexible polymer support (ProTEK formulation) with the aid of standard semiconductor lithographic UV methods can be used. Patterning of the front masking photosensitive polymer and non photosensitive ProTEK formulations using dry etching technology can be used. Additional flexible support layers to enable thicker polymer support membranes can be spin applied prior to wet bulk micromachining. Replacement of the ProTek back protective and support coating with Waferbond protective and supporting membrane is also envisaged. Fabrication of Hollow MicroNeedles on a flexible polymer support of ProTEK formulations or Waferbond is also envisaged.

## Claims

1. A method of fabricating a microneedle device of the type comprising silicon microneedles formed on a flexible polymer support layer, the method comprising the steps of:
- providing a silicon substrate having a surface oriented in the <100> crystal direction, the substrate having a back face and a front face, the back face having a flexible polymer support layer that is resistant to wet-etching, and the front face having a patterned protective masking layer including openings through which etching reagents act on the silicon substrate; and
- wet-etching the silicon substrate through the patterned protective masking layer to provide silicon microneedles formed on the flexible polymer support layer.

2. A method as claimed in Claim 1 in which the method comprises initial steps of providing a silicon substrate with a dielectric hard mask on the front and rear faces of the substrate, patterning the dielectric hard mask on the front face to provide the patterned protective masking layer, removing the dielectric hard mask on the rear face, and applying the flexible polymer support layer that is resistant to wet-etching to the rear face before wet-etching the front face.

3. A method as claimed in Claim 1 in which the method comprises initial steps of providing a silicon substrate with a dielectric hard mask on the front face of the substrate and flexible polymer support layer that is resistant to wet-etching on the rear face of the substrate, and patterning the dielectric hard mask on the front face to provide the patterned protective masking layer before wet-etching the front face.

4. A method as claimed in Claim 2 or 3 in which the dielectric hard mask comprises an oxide and/or a nitride layer.

5. A method as claimed in Claim 1 in which the flexible polymer support layer on the rear face of the silicon substrate is a photosensitive and or non-photosensitive flexible polymer protective coating, and the protective masking layer on the front face of the silicon substrate is a patterned photosensitive flexible polymer protective coating.

6. A method as claimed in Claim 6 in which the photosensitive flexible polymer protective coating is patterned by semiconductor lithographic UV methods.

7. A method as claimed in any preceding Claim and including a further step of spin-coating an addition flexible polymer layer on top of the flexible polymer support layer, partially embedding the microneedles.

8. A method as claimed in any preceding Claim in which the silicon substrate is from 200 to 500 microns thick and the flexible polymer coating is from 0.2um to 200 microns thick, respectively.

9. A method as claimed in any preceding Claim in which the wet-etching is carried out using an alkaline wet etchant selected from the group consisting of: potassium hydroxide (KOH); tetramethylammonium hydroxide (TMAH); and ethylene diamine pyrocathecol (EDP).

10. A microneedle device comprising an array of silicon microneedles formed on a flexible polymer support layer, wherein the flexible polymer support layer comprises a material that is resistant to wet-etching.

11. A microneedle device as claimed in Claim 10 in which the flexible polymer coating is from 0.2um to 200 microns thick.

12. A microneedle device as claimed in Claim 10 or 11 and comprising a further flexible polymer layer on top of the flexible polymer support layer, in which the further flexible polymer layer partially embeds the microneedles.

13. A microneedles device as claimed in any of Claims 10 to 12 in which at least a portion of the microneedles are hollow.

14. A patch, plaster or bandage suitable for transdermal delivery of a drug comprising a microneedle device of any of Claims 1 to 10.
